# EUROPEAN PATENT APPLICATION

(11) **EP 4 680 002 A1**
(43) Date of publication of application: **14.01.2026**
(21) Application number: 23926341.1
(22) Date of filing: 09.03.2023
(51) Int. Cl.: H10N 60/12

(54) **QUANTUM DEVICE AND METHOD FOR MANUFACTURING QUANTUM DEVICE**

(71) Applicant: FUJITSU LIMITED, Kawasaki-shi, Kanagawa 211-8588 (JP)
(72) Inventor: SAIDA, Daisuke, Kawasaki-shi, Kanagawa 211-8588 (JP)
(74) Representative: Haseltine Lake Kempner LLP
(86) International application number: PCT/JP2023/009066
(87) International publication number: WO 2024/185131

(57) **Abstract**

A quantum device includes a first qubit substrate, a second qubit substrate, and a capacitive coupling substrate, the first qubit substrate includes a first qubit and a first electrode coupled to the first qubit, the second qubit substrate includes a second qubit and a second electrode coupled to the second qubit, and the capacitive coupling substrate includes a third electrode capacitively coupled to the first electrode and the second electrode, a shield layer covering the first qubit and the second qubit, and an insulating film provided between the third electrode and the shield layer. The quantum device can be used in quantum computing, for example.

## Description

### TECHNICAL FIELD

The present disclosure relates to quantum devices, and methods for manufacturing quantum devices.

### BACKGROUND ART

In quantum devices including qubits, increasing the number of qubits are being studied to expand computational capacity. Accordingly, there is a proposed quantum device including a plurality of qubit substrates formed with qubits.

### PRIOR ART DOCUMENTS

### PATENT DOCUMENTS

Patent Document 1: U.S. Patent No. 10,068,181
Patent Document 2: U.S. Patent Application Publication No. 2019/0207075
Patent Document 3: U.S. Patent Application Publication No. 2022/0189922
Patent Document 4: Japanese National Publication of International Patent Application No. 2021-534583

### NON-PATENT DOCUMENTS

Non-Patent Document 1: A. Gold et al., npj 7 (2021) 142

### DISCLOSURE OF THE INVENTION

### PROBLEM TO BE SOLVED BY THE INVENTION

In order to increase the number of qubits, there are studies to capacitively couple substrates formed with the qubits to each other using another substrate (capacitive coupling substrate) opposing the substrates, and to interconnect the multiple qubits. In addition, the quantum device is required to shield the qubits from external electromagnetic waves.

One object of the present disclosure is to provide a quantum device and a method for manufacturing the quantum device capable of interconnecting qubits using a capacitive coupling substrate and shielding the qubits from external electromagnetic waves.

### MEANS OF SOLVING THE PROBLEM

According to one aspect of the present disclosure, a quantum device includes a first qubit substrate; a second qubit substrate; and a capacitive coupling substrate, wherein the first qubit substrate includes a first qubit, and a first electrode coupled to the first qubit, the second qubit substrate includes a second qubit, a second electrode coupled to the second qubit, the capacitive coupling substrate includes a third electrode capacitively coupled to the first electrode and the second electrode, a shield layer covering the first qubit and the second qubit, and an insulating film provided between the third electrode and the shield layer.

### EFFECTS OF THE INVENTION

According to the present disclosure, it is possible to interconnect the qubits and to shield the qubits from external electromagnetic waves.

### BRIEF DESCRIPTION OF THE DRAWINGS

[FIG. 1] FIG. 1 is a cross sectional view illustrating a quantum device according to a first embodiment.
[FIG. 2] FIG. 2 is a top view illustrating a first qubit substrate and a second qubit substrate in the quantum device according to the first embodiment.
[FIG. 3] FIG. 3 is a bottom view illustrating a capacitive coupling substrate in the quantum device according to the first embodiment.
[FIG. 4] FIG. 4 is a cross sectional view illustrating a method for using the quantum device according to the first embodiment.
[FIG. 5] FIG. 5 is a cross sectional view illustrating a quantum device according to a reference example.
[FIG. 6] FIG. 6 is a cross sectional view (part 1) illustrating a first example of a method for manufacturing a capacitive coupling substrate in the first embodiment.
[FIG. 7] FIG. 7 is a cross sectional view (part 2) illustrating the first example of the method for manufacturing the capacitive coupling substrate in the first embodiment.
[FIG. 8] FIG. 8 is a cross sectional view (part 3) illustrating the first example of the method for manufacturing the capacitive coupling substrate in the first embodiment.
[FIG. 9] FIG. 9 is a cross sectional view (part 4) illustrating the first example of the method for manufacturing the capacitive coupling substrate in the first embodiment.
[FIG. 10] FIG. 10 is a cross sectional view (part 1) illustrating a second example of the method for manufacturing the capacitive coupling substrate in to the first embodiment.
[FIG. 11] FIG. 11 is a cross sectional view (part 2) illustrating the second example of the method for manufacturing the capacitive coupling substrate in the first embodiment.
[FIG. 12] FIG. 12 is a cross sectional view (part 3) illustrating the second example of the method for manufacturing the capacitive coupling substrate in the first embodiment.
[FIG. 13] FIG. 13 is a bottom view illustrating a capacitive coupling substrate in the quantum device according to a second embodiment.
[FIG. 14] FIG. 14 is a cross sectional view illustrating the quantum device according to a third embodiment.
[FIG. 15] FIG. 15 is a cross sectional view illustrating the quantum device according to a fourth embodiment.
[FIG. 16] FIG. 16 is a cross sectional view illustrating the quantum device according to a fifth embodiment.
[FIG. 17] FIG. 17 is a cross sectional view illustrating the quantum device according to a sixth embodiment.
[FIG. 18] FIG. 18 is a top view illustrating a first qubit substrate and a second qubit substrate in the quantum device according to the sixth embodiment.
[FIG. 19] FIG. 19 is a cross sectional view illustrating the quantum device according to a seventh embodiment.

### MODE OF CARRYING OUT THE INVENTION

Hereinafter, embodiments of the present disclosure will be specifically described with reference to the accompanying drawings. In the present specification and the drawings, constituent elements having substantially the same functional configuration are designated by the same reference numerals, and a redundant description thereof may be omitted. In the present disclosure, an X1-X2 direction, a Y1-Y2 direction, and a Z1-Z2 direction are defined as directions perpendicular to one another. A plane including the X1-X2 direction and the Y1-Y2 direction is described as an XY-plane, a plane including the Y1-Y2 direction and the Z1-Z2 direction is described as a YZ-plane, and a plane including the Z1-Z2 direction and the X1-X2 direction is described as a ZX-plane. For the sake of convenience, the Z1-Z2 direction is defined as a vertical direction, the Z1-side is defined as an upper side, and the Z2-side is defined as a lower side. In addition, a plan view refers to view of an object viewed from the Z1-side, and a planar shape refers to a shape of the object in the plan view viewed from the Z1-side.

In quantum devices including qubits, there are demands in recent years for a quantum device capable of achieving a large-scale qubit computation. In order to satisfy such demands, multi-qubit technologies are required to interconnect the multiple qubits, and as one of the multi-bit technologies, a conceivable technique interconnects qubit substrates formed with the qubits to each other using another substrate opposing the qubit substrates. Specifically, a coupling substrate is disposed so as to oppose the qubit substrates, and electrodes for coupling the qubits are provided on the coupling substrate, so that the qubits can be interconnected. The present inventor further conducted diligent studies on a structure for providing the coupling substrate with a shielding function to shield the qubits from external electromagnetic waves.

### (First Embodiment)

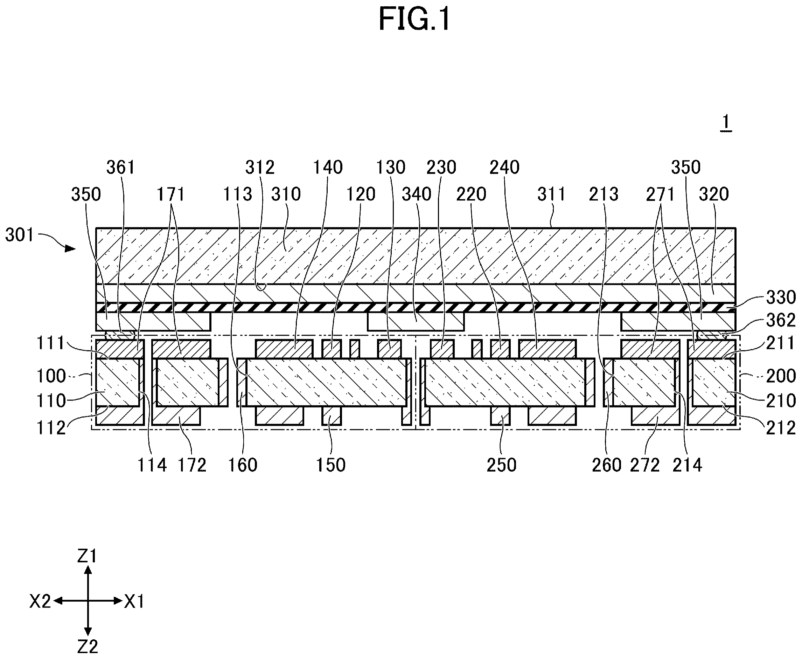

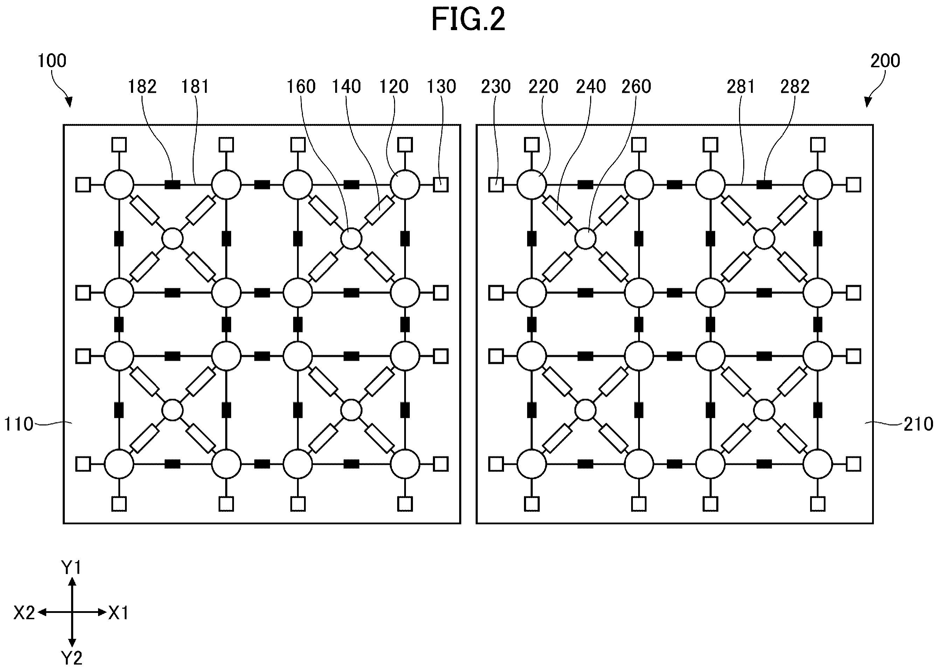

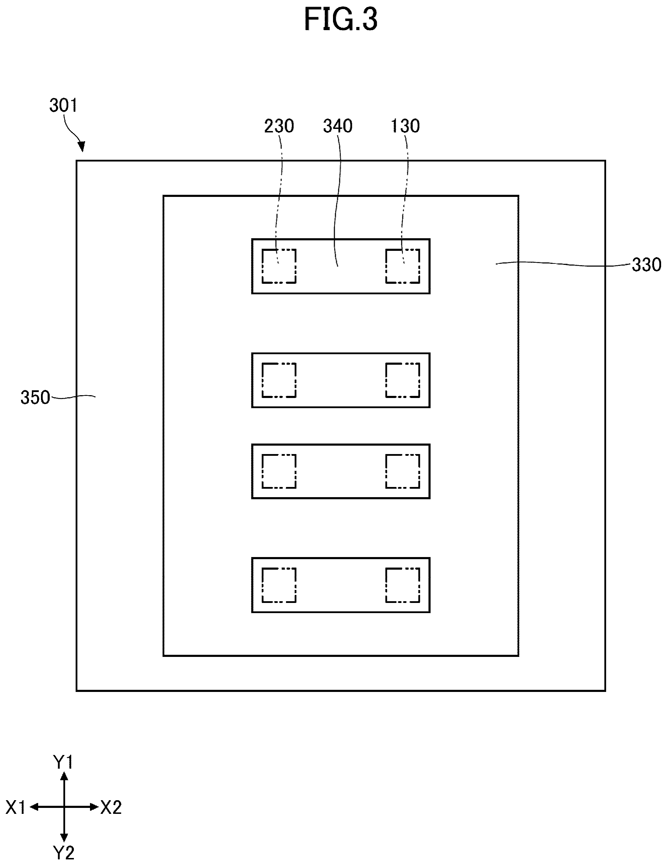

A first embodiment will be described. The first embodiment relates to a quantum device. FIG. 1 is a cross sectional view illustrating the quantum device according to the first embodiment. FIG. 2 is a top view illustrating a first qubit substrate and a second qubit substrate in the quantum device according to the first embodiment. FIG. 3 is a bottom view illustrating a capacitive coupling substrate in the quantum device according to the first embodiment.

As illustrated in FIG. 1 and FIG. 2, a quantum device 1 according to the first embodiment includes a first qubit substrate 100, a second qubit substrate 200, and a capacitive coupling substrate 301. Illustration of the capacitive coupling substrate 301 is omitted in FIG. 2.

The first qubit substrate 100 includes a first substrate 110, a plurality of first qubits 120, a plurality of first electrodes 130, a plurality of first readout circuits 140, a plurality of first input circuits 150, and a plurality of first readout sections 160. The first substrate 110 is a Si substrate, a sapphire substrate, or a MgO substrate, for example. A dielectric loss of the first substrate 110 is preferably 1 x 10⁻³ or less, and more preferably 1 x 10⁻⁴ or less. A resistivity of the first substrate 110 is preferably 0.1 kΩ·cm or greater, and more preferably 1 kΩ·cm or greater. The first substrate 110 has an upper surface 111 on the Z1-side. and a lower surface 112 on the Z2-side. A plurality of first readout through holes 113 and a plurality of first grounding through holes 114 are formed in the first substrate 110. The first qubits 120, the first electrodes 130, and the first readout circuits 140 are provided on the upper surface 111, and the first input circuits 150 are provided on the lower surface 112. The first electrodes 130 and the first readout circuits 140 are coupled to the first qubits 120, respectively. The coupling may be a direct coupling, or an indirect coupling, such as magnetic coupling, capacitive coupling, galvanic coupling, or the like. The first input circuits 150 and the first qubits 120 overlap in the plan view, respectively. The first readout through holes 113 are formed so that the first readout circuit 140 is located between the first readout through hole 113 and the first qubit 120. The first readout sections 160 are provided inside the first readout through holes 113, and are indirectly coupled to the first readout circuits 140 by magnetic coupling, capacitive coupling, galvanic coupling, or the like, respectively.

The first qubit 120 is indirectly coupled to another adjacent first qubit 120 via an inter-bit interconnect 181 by magnetic coupling, capacitive coupling, galvanic coupling, or the like. A capacitor 182 is provided on a path of the inter-bit interconnect 181. Each first qubit 120 creates a quantum entanglement state with another adjacent first qubit 120 to perform a quantum computation.

The first qubits 120, the first electrodes 130, the first readout circuits 140, the first input circuits 150, and the first readout sections 160 are made of a material that becomes a superconductor at cryogenic temperatures, such as Al, Nb, or TiN, for example. A conductive layer 172 that enters inside the first grounding through hole 114 is provided on the lower surface 112, and a conductive layer 171 that connects to the conductive layer 172 is provided on the upper surface 111. The conductive layers 171 and 172 are also made of a material that becomes a superconductor at cryogenic temperatures, such as Al, Nb, TiN, or NbN, for example. The conductive layer 171 is an example of a first conductive layer.

The second qubit substrate 200 includes a second substrate 210, a plurality of second qubits 220, a plurality of second electrodes 230, a plurality of second readout circuits 240, a plurality of second input circuits 250, and a plurality of second readout sections 260. The second substrate 210 is a Si substrate, a sapphire substrate, or a MgO substrate, for example. A dielectric loss of the second substrate 210 is preferably 1 x 10⁻³ or less, and more preferably 1 x 10⁻⁴ or less. A resistivity of the second substrate 210 is preferably 0.1 kΩ·cm or greater, and more preferably 1 kΩ·cm or greater. The second substrate 210 has an upper surface 211 on the Z1-side, and a lower surface 212 on the Z2-side. A plurality of second readout through holes 213 and a plurality of second grounding through holes 214 are formed in the second substrate 210. The second qubits 220, the second electrodes 230, and the second readout circuits 240 are provided on the upper surface 211, and the second input circuits 250 are provided on the lower surface 212. The second electrodes 230 and the second readout circuits 240 are coupled to the second qubits 220, respectively. The coupling may be a direct coupling, or an indirect coupling, such as magnetic coupling, capacitive coupling, galvanic coupling, or the like. The second input circuits 250 and the second qubits 220 overlap in the plan view, respectively. The second readout through holes 213 are formed so that the second readout circuit 240 is located between the second readout through hole 213 and the second qubit 220. The second readout sections 260 are provided inside the second readout through holes 213, and are indirectly coupled to the second readout circuits 240 by magnetic coupling, capacitive coupling, galvanic coupling, or the like, respectively.

The second qubit 220 is indirectly coupled to another adjacent second qubit 220 via a inter-bit interconnect 281 by magnetic coupling, capacitive coupling, galvanic coupling, or the like. A capacitor 282 is provided on a path of the inter-bit interconnect 281. Each second qubit 220 creates a quantum entanglement state with another adjacent second qubit 220 to perform a quantum computation.

The second qubits 220, the second electrodes 230, the second readout circuits 240, the second input circuits 250, and the second readout sections 260 are made of a material that becomes a superconductor at cryogenic temperatures, such as Al, Nb, or TiN, for example. A conductive layer 272 that enters inside the second grounding through hole 214 is provided on the lower surface 212, and a conductive layer 271 that connects to the conductive layer 272 is provided on the upper surface 211. The conductive layers 271 and 272 are also made of a material that becomes a superconductor at cryogenic temperatures, such as Al, Nb, TiN, or NbN, for example. The conductive layer 271 is an example of a second conductive layer.

The capacitive coupling substrate 301 includes a third substrate 310, a shield layer 320, an insulating film 330, third electrodes 340, and a shield layer 350. The third substrate 310 may be a Si substrate with a thermal oxide film. More preferably, the third substrate 310 has a low dielectric loss, and is a Si substrate, a sapphire substrate, or a MgO substrate, for example. The dielectric loss of the third substrate 310 is preferably 1 x 10⁻³ or less, and more preferably 1 x 10⁻⁴ or less. A resistivity of the third substrate 310 is preferably 0.1 kΩ·cm or greater, and more preferably 1 kΩ·cm or greater. The third substrate 310 has an upper surface 311 on the Z1-side, and a lower surface 312 on the Z2-side. The shield layer 320 is provided on the lower surface 312, the insulating film 330 is provided on a lower surface of the shield layer 320, and the third electrodes 340 and the shield layer 350 are provided on a lower surface of the insulating film 330. The insulating film 330 is provided between the shield layer 320 and the third electrodes 340, and between the shield layer 320 and the shield layer 350. The shield layer 320 covers the first qubits 120 and the second qubits 220 from the Z1-side. The shield layer 320, the third electrodes 340, and the shield layer 350 are made of a material that becomes a superconductor at cryogenic temperatures, that is, operating temperatures of the first qubits 120 and the second qubits 220, such as Al, TiN, or NbN, for example. The insulating film 330 is made of an oxide of the material forming the shield layer 320, such as aluminum oxide or, or a nitride of the material forming the shield layer 320, such as aluminum nitride, for example. The shield layer 350 is an example of a third conductive layer.

The third electrodes 340 are arranged in an island-like pattern, and are electrically insulated from the shield layer 320 and the shield layer 350. A potential of the third electrode 340 is a floating potential, for example. The third electrodes 340 have a rectangular planar shape, and sizes (widths) of the third electrodes 340 are constant in the Y1-Y2 direction. In the plan view, each third electrode 340 overlaps one first electrode 130 and one second electrode 230, and the shield layer 350 at least partially overlaps the conductive layers 171 and 271. The third electrode 340 is capacitively coupled to the first electrode 130 and the second electrode 230. The first electrode 130 and the second electrode 230 oppose the third electrode 340, and the first qubits 120 and the second qubits 220 oppose the insulating film 330.

The quantum device 1 includes a conductive bonding material 361 that bonds the conductive layer 171 and the shield layer 350, and a conductive bonding material 362 that bonds the conductive layer 271 and the shield layer 350. A material used for the conductive bonding materials 361 and 362 is In in a case where a superconducting material is to be used, for example, and is Au or Cu in a case where a normal conducting material is to be used, for example. Only the superconducting material, or only the normal conducting material, or both the superconducting material and the normal conducting material may be used for the conductive bonding materials 361 and 362.

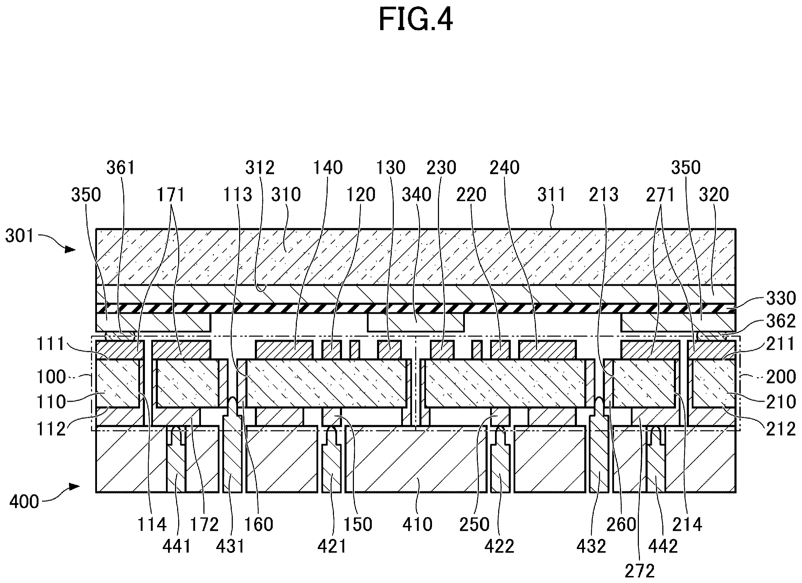

The quantum device 1 is used with a probe substrate attached thereto, for example. FIG. 4 is a cross sectional view illustrating a method for using the quantum device 1 according to the first embodiment.

As illustrated in FIG. 4, a probe substrate 400 includes a base material 410, a plurality of first input probes 421, a plurality of second input probes 422, a plurality of first readout probes 431, a plurality of second readout probes 432, a plurality of first ground probes 441, and a plurality of second ground probes 442. The first input probes 421, the second input probes 422, the first readout probes 431, the second readout probes 432, the first ground probes 441, and the second ground probes 442 may be fixed to the base material 410. For example, the first input probes 421, the second input probes 422, the first readout probes 431, and the second readout probes 432 may be coaxial pins, and the coaxial pins may have a mechanical telescoping mechanism. Each first input probe 421 contacts one first input circuit 150, and each second input probe 422 contacts one second input circuit 250. Each first readout probe 431 contacts one first readout section 160, and each second readout probe 432 contacts one second readout section 260. Each first ground probe 441 contacts the conductive layer 172, and each second ground probe 442 contacts the conductive layer 272.

A ground potential is supplied from the first ground probes 441 and the second ground probes 442 to the conductive layers 171, 172, 271, and 272 and the shield layer 350. Signals for inducing state transitions of the first qubits 120 are supplied from the first input probes 421 to the first input circuits 150, respectively, and signals for inducing state transitions of the second qubits 220 are supplied from the second input probes 422 to the second input circuits 250, respectively. The states of the first qubits 120 are read from the first readout probes 431, respectively, and the states of the second qubits 220 are read from the second readout probes 432, respectively.

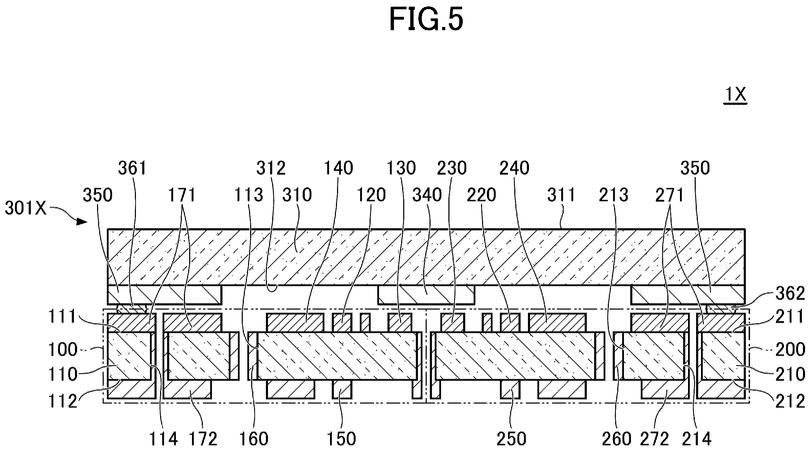

Next, effects of the first embodiment will be described in comparison with a reference example. FIG. 5 is a cross sectional view illustrating a quantum device according to the reference example.

The quantum-device 1X according to the reference example includes a capacitive coupling substrate 301X in place of the capacitive coupling substrate 301. The capacitive coupling substrate 301X does not include the shield layer 320 and the insulating film 330, and the third electrodes 340 and the shield layer 350 are provided on the lower surface 312 of the third substrate 310. The configuration is otherwise the same as that of the first embodiment.

In both the quantum devices 1 and 1X, the third electrodes 340 are capacitively coupled to the first electrodes 130 and the second electrodes 230. Accordingly, the first electrode 130 and the second electrode 230 are capacitively coupled via the third electrode 340. For example, a strength of the capacitive coupling between the first electrode 130 and the second electrode 230 is equal to a strength of the capacitive coupling between the adjacent first qubits 120 in the first qubit substrate 100, and equal to a strength of the capacitive coupling between the adjacent second qubits 220 in the second qubit substrate 200.

However, in the quantum device 1, the shield layer 320 is present above the first qubits 120 and the first readout circuits 140, whereas in the quantum device 1X, the shield layer 320 is not present above the first qubits 120 and the first readout circuits 140. For this reason, in the quantum device 1, a good shielding effect can be obtained against electromagnetic waves from above toward the first qubits 120 and the first readout circuits 140, but in the case of the quantum device 1X, the electromagnetic waves from above can easily reach the first qubits 120 and the first readout circuits 140. Similarly, in the quantum device 1, a good shielding effect can be obtained against the electromagnetic waves from above toward the second qubits 220 and the second readout circuits 240, but in the case of the quantum device 1X, the electromagnetic waves from above can easily reach the second qubits 220 and the second readout circuits 240.

In addition, in the quantum device 1, the dielectric loss of the third substrate 310 is unlikely to affect the first qubits 120 and the first readout circuits 140 due to the presence of the shield layer 320, but in the quantum device 1X, the dielectric loss of the third substrate 310 is likely to affect the first qubits 120 and the first readout circuits 140. Similarly, in the quantum device 1, the dielectric loss of the third substrate 310 is unlikely to affect the second qubits 220 and the second readout circuits 240, but in the quantum device 1X, the dielectric loss of the third substrate 310 is likely to affect the second qubits 220 and the second readout circuits 240.

As described above, according to the first embodiment, it is possible to obtain a shielding effect while interconnecting the qubits, and to suppress a decrease in coherence caused by the dielectric loss.

Moreover, in regions of the capacitive coupling substrate 301 opposing the first qubits 120 and the second qubits 220, no conductive member is provided between the insulating film 330 and the first qubits 120, and no conductive member is provided between the insulating film 330 and the second qubits 220. Hence, it is possible to suppress stray parasitic capacitances associated with the first qubits 120 and the second qubits 220.

When using the quantum device 1, a space between the capacitive coupling substrate 301 and each of the first qubit substrate 100 and the second qubit substrate 200 may be sealed in a vacuum state or in a state filled with an inert gas. In this case, it is possible to more stably operate the first qubits 120 and the second qubits 220.

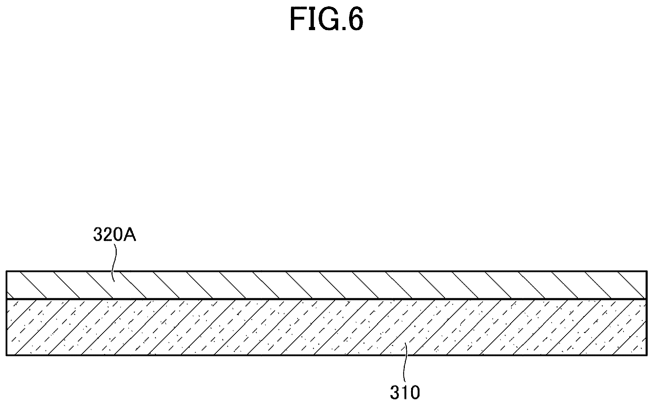

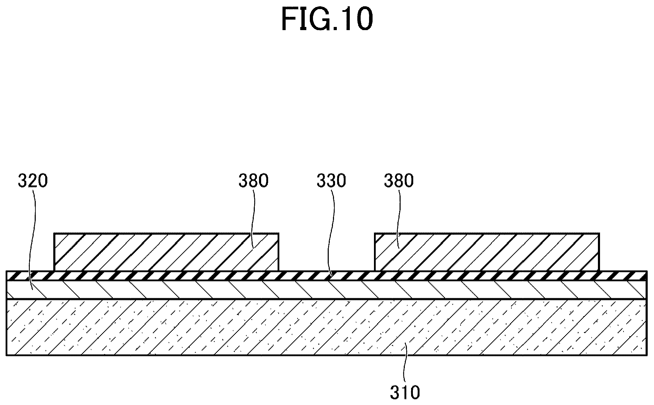

Next, a method for manufacturing the capacitive coupling substrate 301 will be described. FIG. 6 through FIG. 9 are cross sectional views illustrating a first example of the method for manufacturing the capacitive coupling substrate 301, and FIG. 10 through FIG. 12 are cross sectional views illustrating a second example of the method for manufacturing the capacitive coupling substrate 301.

In the first example, first, as illustrated in FIG. 6, a first layer 320A that becomes the shield layer 320 is formed on a surface that becomes the lower surface 312 of the third substrate 310. The first layer 320A can be formed by a vapor deposition, for example. The first layer 320A is made of Al or TiN, for example.

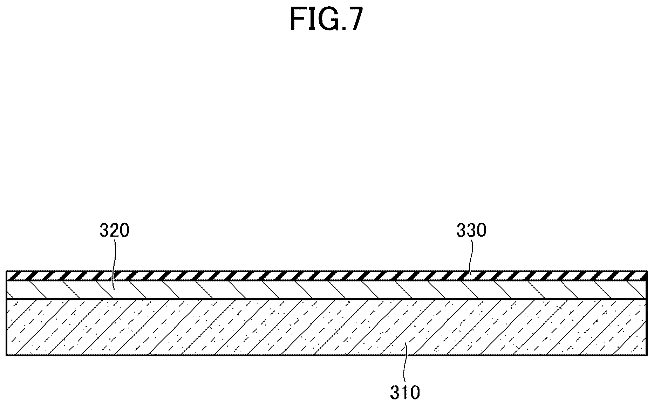

Next, as illustrated in FIG. 7, a surface of the first layer 320A is oxidized to form the insulating film 330. The remaining portion of the first layer 320A becomes the shield layer 320. The insulating film 330 can be formed by forced oxidation or natural oxidation, for example. In the case where the first layer 320A is an Al film, this step of forming the first layer 320A may be a nitridation step of nitriding the first layer 320A.

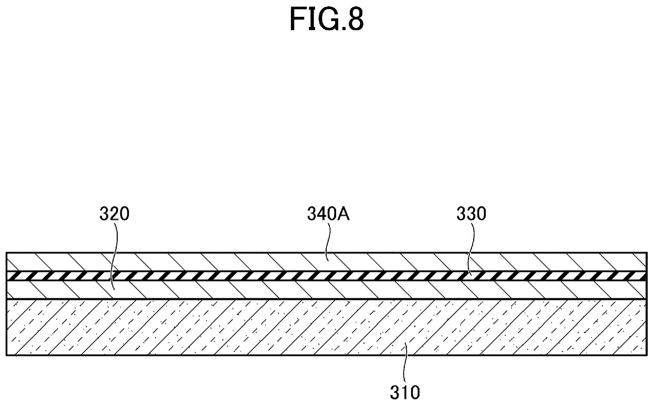

Next, as illustrated in FIG. 8, a second layer 340A that becomes the third electrodes 340 and the shield layer 350 is formed on the insulating film 330. The second layer 340A can be formed by vapor deposition, for example. The second layer 340A is made of Al or TiN, for example.

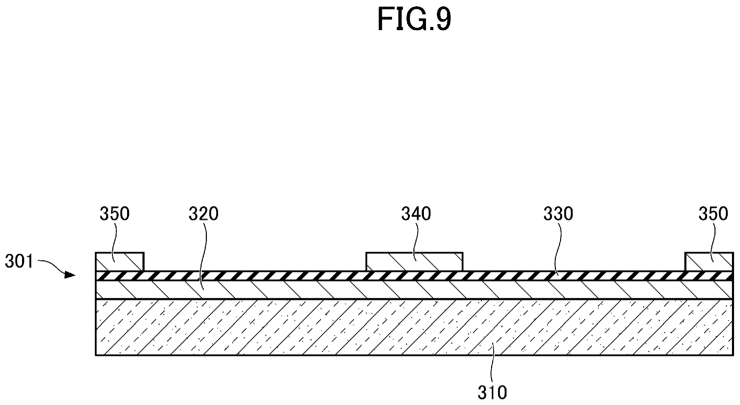

Subsequently, as illustrated in FIG. 9, the second layer 340A is processed by etching, for example, to form the third electrodes 340 and the shield layer 350. The capacitive coupling substrate 301 can be manufactured in this manner.

In the second example, first, the processes up to the formation of the insulating film 330 are performed in the same manner as in the first example. Next, as illustrated in FIG. 10, a resist pattern 380 is formed. The resist pattern 380 has openings in portions where the third electrodes 340 are formed and a portion where the shield layer 350 is formed.

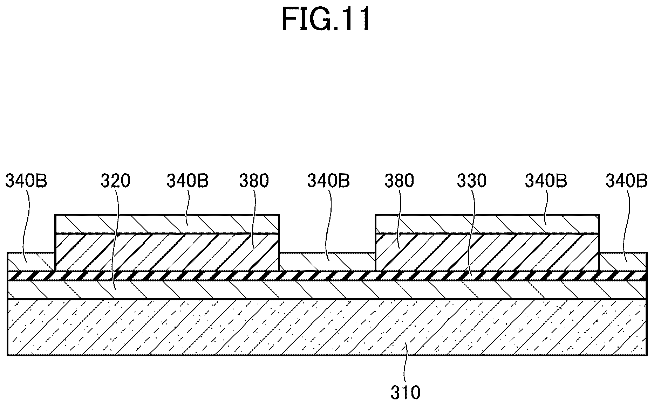

Thereafter, as illustrated in FIG. 11, a third layer 340B that becomes the third electrodes 340 and the shield layer 350 is formed on the insulating film 330 and the resist pattern 380. The third layer 340B can be formed by vapor deposition, for example. The third layer 340B is made of Al or TiN, for example.

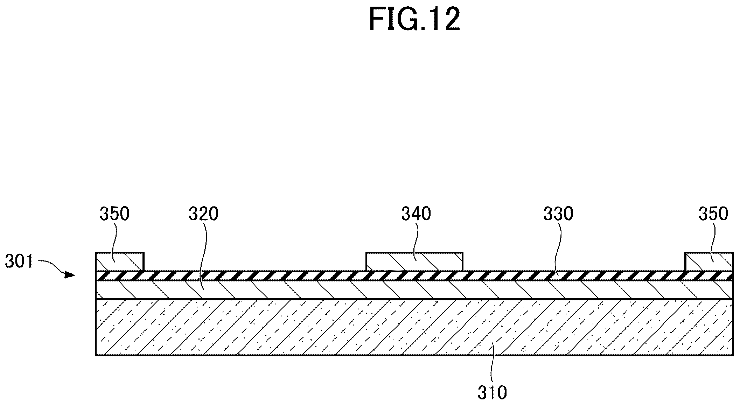

Next, as illustrated in FIG. 12, the resist pattern 380 is removed. By removing the resist pattern 380, the third layer 340B formed on the resist pattern 380 is also removed. As a result, the third electrode 340 and the shield layer 350 are formed. The capacitive coupling substrate 301 can be manufactured in this manner.

When manufacturing the quantum device 1, the first qubit substrate 100 and the second qubit substrate 200 are prepared, and the capacitive coupling substrate 301 is prepared by the method described above. Then, the first qubit substrate 100 and the second qubit substrate 200 are bonded to the capacitive coupling substrate 301. The conductive bonding materials 361 and 362 are used to perform the bonding. The quantum device 1 can be manufactured in this manner.

The potential of the shield layer 320 is not limited, and may be a floating potential or a ground potential, for example. However, the potential of the shield layer 320 is preferably a floating potential rather than a ground potential. This is because, by setting the potential of the shield layer 320 to the floating potential, a transmittance of an external electromagnetic field passing through the shield layer 320 can be reduced, and the ground potential of the conductive layers 171 and 271 and the shield layer 350 can easily be stabilized.

### (Second Embodiment)

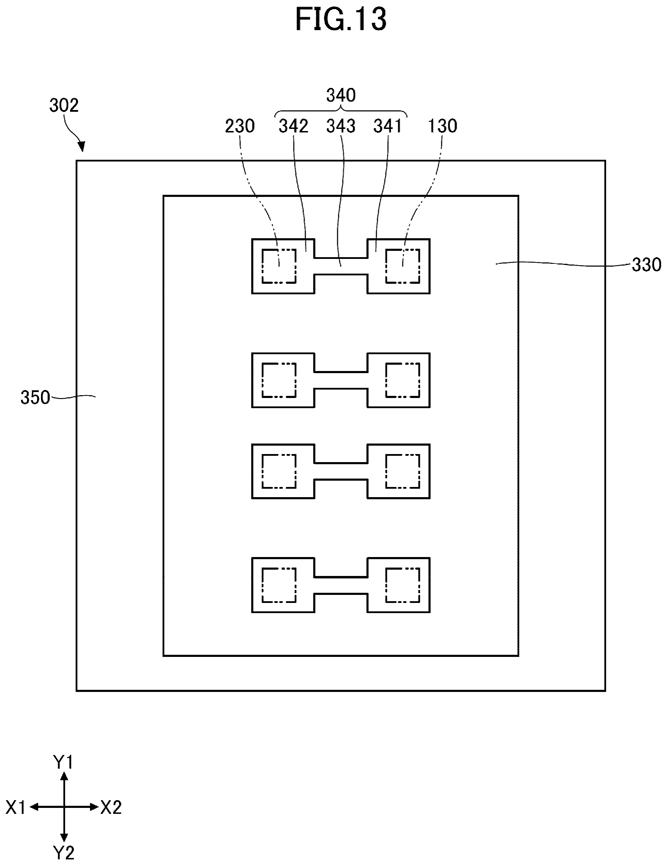

Next, a second embodiment will be described. The second embodiment differs from the first embodiment mainly in the planar shape of the third electrodes. FIG. 13 is a bottom view illustrating the capacitive coupling substrate in the quantum device according to the second embodiment.

As illustrated in FIG. 13, the quantum device according to the second embodiment includes a capacitive coupling substrate 302 in place of the capacitive coupling substrate 301. In the capacitive coupling substrate 302, the third electrode 340 includes a first region 341, a second region 342, and a third region 343. The first region 341 opposes the first electrode 130, and the second region 342 opposes the second electrode 230. The third region 343 is continuous with the first region 341 and the second region 342, and is located between the first region 341 and the second region 342. The size of the third electrode 340 in the Y1-Y2 direction (second direction) is smaller in the third region 343 than in the first region 341 and the second region 342. The Y1-Y2 direction is a direction perpendicular to the X1-X2 direction (first direction) in which the first electrodes 130 and the second electrodes 230 are arranged in the plan view.

Otherwise, the configuration of the second embodiment is the same as that of the first embodiment.

The second embodiment can also obtain the same effects as those obtainable in the first embodiment. In the second embodiment, the size of the third electrode 340 in the Y1-Y2 direction is smaller in the third region 343 than in the first region 341 and the second region 342, and thus, it is possible to make the third electrode 340 less susceptible to flux quantum trapping.

### (Third Embodiment)

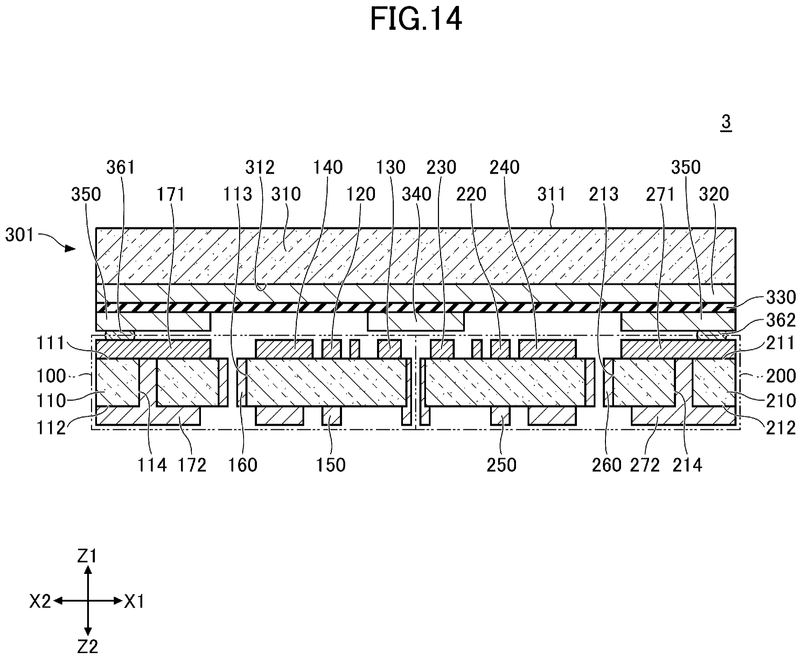

Next, a third embodiment will be described. The third embodiment differs from the first embodiment mainly in the configurations of the first qubit substrate and the second qubit substrate. FIG. 14 is a cross sectional view illustrating the quantum device according to the third embodiment.

As illustrated in FIG. 14, in a quantum device 3 according to the third embodiment, the first grounding through hole 114 is filled with a conductive layer 172, and the second grounding through hole 214 is filled with a conductive layer 272.

Otherwise, the configuration of the third embodiment is the same as that of the first embodiment.

The third embodiment can also obtain the same effects as those obtainable in the first embodiment.

### (Fourth Embodiment)

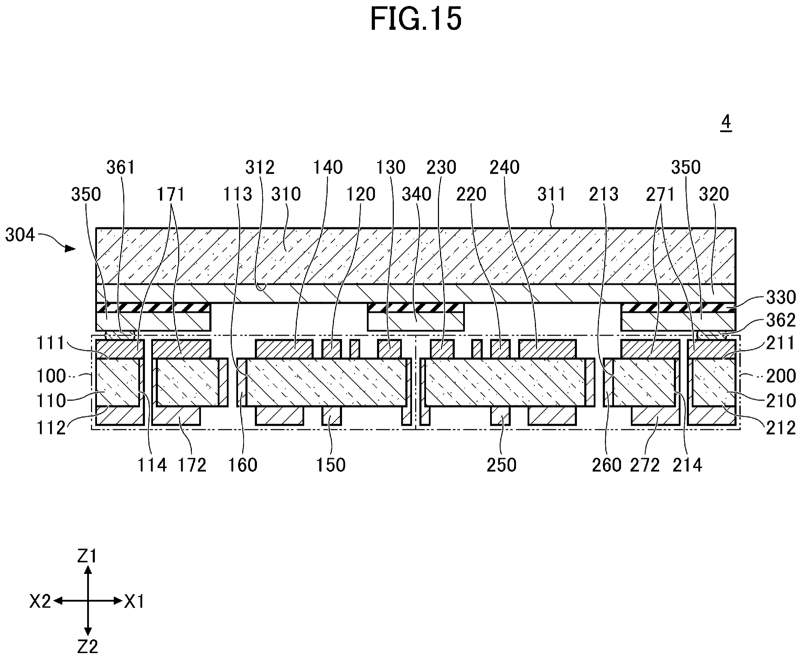

Next, a fourth embodiment will be described. The fourth embodiment differs from the first embodiment mainly in the configuration of the capacitive coupling substrate. FIG. 15 is a cross sectional view illustrating the quantum device according to the fourth embodiment.

As illustrated in FIG. 15, a quantum device 4 according to the fourth embodiment includes a capacitive coupling substrate 304 instead of the capacitive coupling substrate 301. In the capacitive coupling substrate 304, the insulating film 330 is formed only between the third electrode 340 and the shield layer 320, and between the shield layer 350 and the shield layer 320, and no insulating film 330 is formed between the third electrode 340 and the shield layer 350 in the plan view. Accordingly, the lower surface of the shield layer 320 is exposed through the insulating film 330.

Otherwise, the configurations of the fourth embodiment is the same as that of the first embodiment.

The fourth embodiment can also obtain the same effects as those obtainable in the first embodiment.

### (Fifth Embodiment)

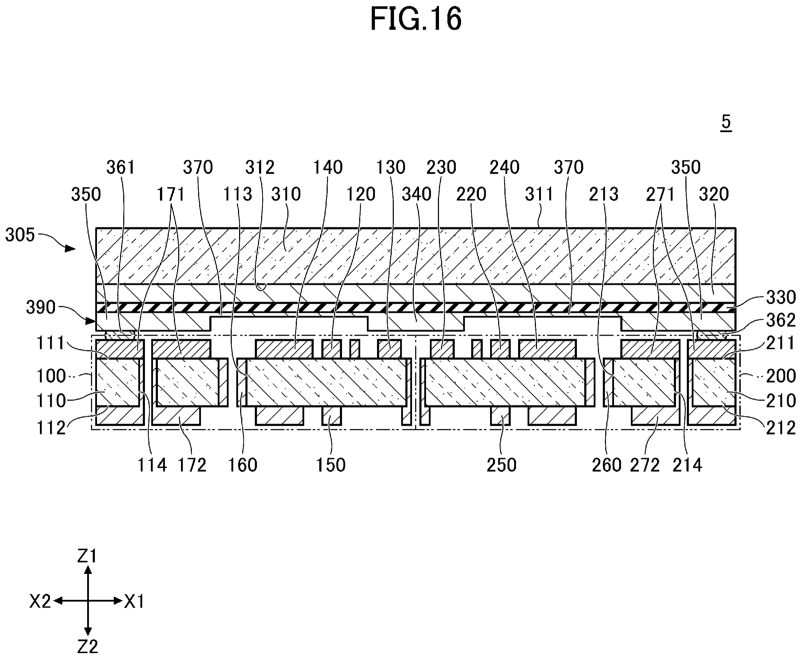

Next, a fifth embodiment will be described. The fifth embodiment differs from the first embodiment mainly in the configuration of the capacitive coupling substrate. FIG. 16 is a cross sectional view illustrating the quantum device according to the fifth embodiment.

As illustrated in FIG. 16, a quantum device 5 according to the fifth embodiment includes a capacitive coupling substrate 305 in place of the capacitive coupling substrate 301. The capacitive coupling substrate 305 includes a conductive layer 390 formed on the insulating film 330. The conductive layer 390 includes the third electrodes 340 and the shield layer 350. In addition, the conductive layer 390 is formed so that a film thickness at least in the regions opposing the first qubits 120 and the second qubits 220 is thinner than that in the regions of the third electrode 340 and the shield layer 350. For example, as illustrated in FIG. 8 and FIG. 9, the third electrodes 340 and the shield layer 350 are formed by etching the second layer 340A on the insulating film 330. Similarly, in the present embodiment, when the conductive member formed on the insulating film 330 is partially removed by etching to form the third electrodes 340 and the shield layer 350, the conductive member on the insulating film 330 is not completely removed and remains between the third electrodes 340 and the shield layer 350, thereby forming the conductive layer 390.

Otherwise, the configuration of the fifth embodiment is the same as that of the first embodiment.

According to the fifth embodiment, similar to the first embodiment, a good shielding effect can be obtained, and a decrease in coherence caused by the dielectric loss can be suppressed. In addition, because the thickness of the conductive layer 390 at least in the regions opposing the first qubits 120 and the second qubits 220 of the capacitive coupling substrate 305 is thinner than that in other regions, it is possible to suppress the stray parasitic capacitances associated with the first qubits 120 and the second qubits 220.

### (Sixth Embodiment)

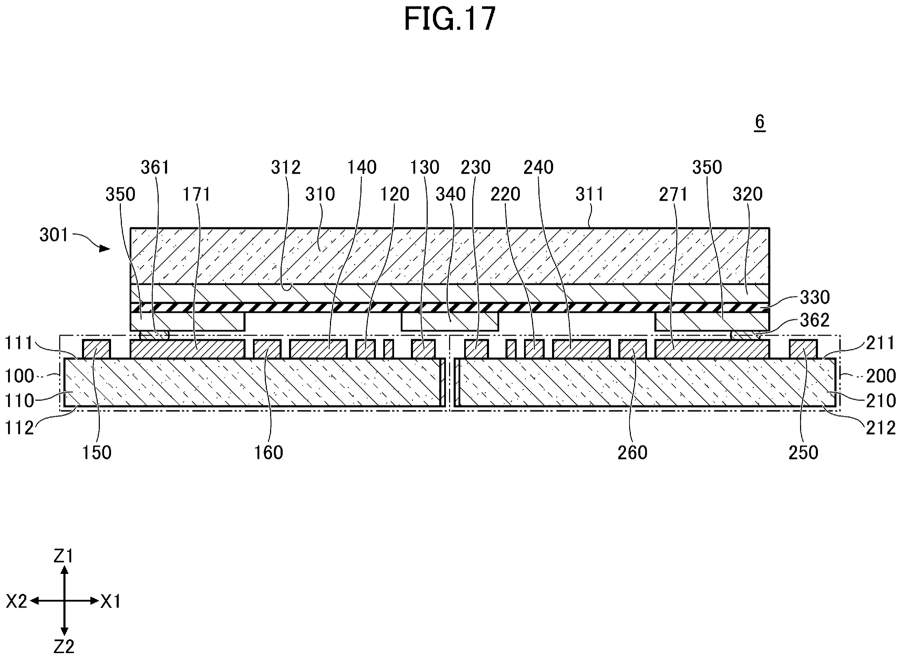

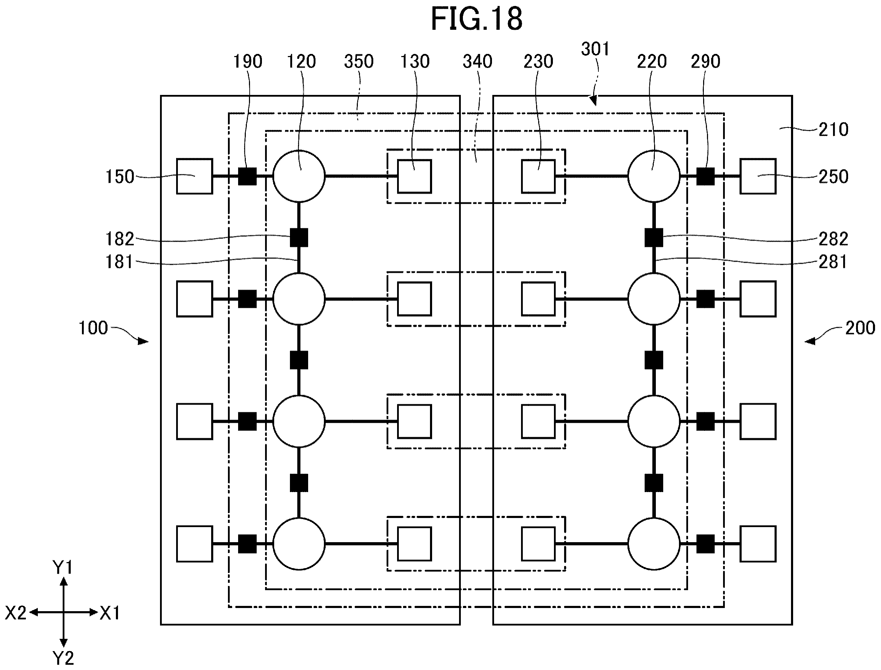

Next, a sixth embodiment will be described. The sixth embodiment differs from the first embodiment mainly in the configurations of the first qubit substrate and the second qubit substrate. FIG. 17 is a cross sectional view illustrating the quantum device according to the sixth embodiment. FIG. 18 is a top view illustrating the first qubit substrate and the second qubit substrate in the quantum device according to the sixth embodiment.

As illustrated in FIG. 17 and FIG. 18, in a quantum device 6 according to the sixth embodiment, the first readout through holes 113 and the first grounding through holes 114 are not formed in the first qubit substrate 100, and the first qubit substrate 100 does not have the conductive layer 172. The first input circuits 150 are provided on the upper surface 111 of the first substrate 110. A capacitor 190 is connected between the first qubit 120 and the first input circuit 150. Similarly, the second readout through holes 213 and the second grounding through holes 214 are not formed in the second qubit substrate 200, and the first qubit substrate 100 does not have the conductive layer 172. The second input circuits 250 are provided on the upper surface 211 of the second substrate 210. A capacitor 290 is connected between the second qubit 220 and the second input circuit 250.

In the plan view, the first input circuits 150 and the second input circuits 250 are exposed through the capacitive coupling substrate 301. Bonding wires are connected to the first input circuits 150 and the second input circuits 250, respectively. In the sixth embodiment, the signals for inducing the state transitions of the first qubits 120 and the second qubits 220 are input from the bonding wires, not from the first input probes 421 and the second input probes 422.

Otherwise, the configuration of the sixth embodiment is the same as that of the first embodiment.

The sixth embodiment can also obtain the same effects as those obtainable in the first embodiment.

### (Seventh Embodiment)

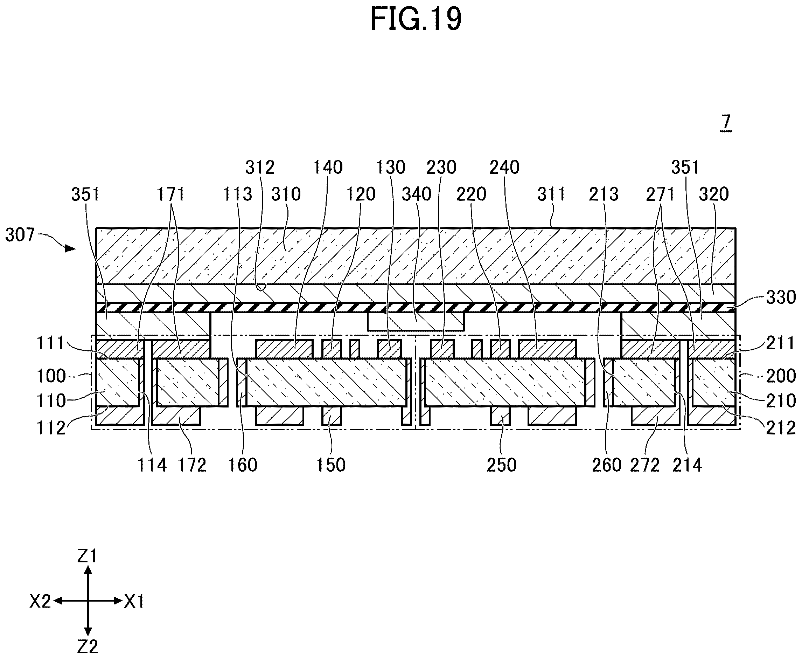

Next, a seventh embodiment will be described. The seventh embodiment differs from the first embodiment mainly in the configuration of the capacitive coupling substrate. FIG. 19 is a cross sectional view illustrating the quantum device according to the seventh embodiment.

As illustrated in FIG. 19, a quantum device 7 according to the seventh embodiment includes a capacitive coupling substrate 307 in place of the capacitive coupling substrate 301. The capacitive coupling substrate 307 includes a shield layer 351 in place of the shield layer 350. The shield layer 351 is thicker than the third electrodes 340. The shield layer 351 is made of the same material as the third electrodes 340, for example.

The quantum device 7 does not include the conductive bonding materials 361 and 362, and the shield layer 351 is directly bonded to the conductive layers 171 and 271. The shield layer 351 is bonded to the conductive layers 171 and 271 by diffusion bonding, for example.

Otherwise, the configuration of the seventh embodiment is the same as that of the first embodiment.

The seventh embodiment can also obtain the same effects as those obtainable in the first embodiment.

In each of the embodiments, a stacked structure of the shield layer 320 and the insulating film 330 may be repeatedly provided. Further, the quantum device may include three or more qubit substrates.

The quantum device according to the present disclosure can be used for quantum computing, for example.

Although the preferred embodiments or the like are described above in detail, the present disclosure is not limited to the embodiments or the like described above, and various modifications and substitutions can be made without departing from the scope recited in the claims.

### DESCRIPTION OF REFERENCE NUMERALS

1, 3, 4, 5, 6, 7: quantum device
100: first qubit substrate
110: first substrate
120: first qubit
130: first electrode
200: second qubit substrate
210: second substrate
220: second qubit
230: second electrode
301, 302, 304, 305, 307: capacitive coupling
substrate
310: third substrate
320: shield layer
330: insulating film
340: third electrode
341: first region
342: second region
343: third region
350, 351, 370: shield layer
390: conductive layer

## Claims

1. A quantum device **characterized in that** there are provided:
a first qubit substrate;
a second qubit substrate; and
a capacitive coupling substrate, wherein:
the first qubit substrate includes:
a first qubit; and
a first electrode coupled to the first qubit,
the second qubit substrate includes:
a second qubit;
a second electrode coupled to the second qubit,
the capacitive coupling substrate includes:
a third electrode capacitively coupled to the first electrode and the second electrode;
a shield layer covering the first qubit and the second qubit; and
an insulating film provided between the third electrode and the shield layer.

2. The quantum device as claimed in claim 1,
**characterized in that**:
the first qubit substrate includes N pairs of the first qubit and the first electrode (N is an integer greater than or equal to 2,
the second qubit substrate includes N sets of the second qubit and the second electrode,
the capacitive coupling substrate includes N third electrodes, and
the N third electrodes are electrically insulated from one another.

3. The quantum device as claimed in claim 1 or 2, **characterized in that** the third electrode includes:
a first region opposing the first electrode;
a second region opposing the second electrode; and
a third region connected to the first region and the second region, and located between the first region and the second region,
wherein the first electrode and the second electrode are arranged in a first direction, and a size of the third electrode in a second direction perpendicular to the first direction in a plan view in the third region is smaller than sizes of the first region and the second region.

4. The quantum device as claimed in claim 1 or 2, **characterized in that** a potential of the third electrode is a floating potential.

5. The quantum device as claimed in claim 1 or 2, **characterized in that**:
the first qubit substrate includes a first substrate and a first conductive layer,
the second qubit substrate includes a second substrate and a second conductive layer,
the capacitive coupling substrate includes a third substrate and a third conductive layer, wherein:
the first qubit, the first electrode, and the first conductive layer are provided on a side of the first substrate adjacent to the capacitive coupling substrate,
the second qubit, the second electrode, and the second conductive layer are provided on a side of the second substrate adjacent to the capacitive coupling substrate,
the third conductive layer is provided on a side of the insulating film adjacent to the first qubit substrate and the second qubit substrate,
the first conductive layer and the third conductive layer are directly bonded, and
the second conductive layer and the third conductive layer are directly bonded.

6. The quantum device as claimed in claim 1 or 2, **characterized in that** the third electrode becomes a superconductor at temperatures at which the first qubit and the second qubit operate.

7. The quantum device as claimed in claim 6, **characterized in that** the third electrode includes Al or TiN.

8. The quantum device as claimed in claim 1 or 2, **characterized in that** the shield layer becomes a superconductor at temperatures at which the first qubit and the second qubit operate.

9. The quantum device as claimed in claim 8, **characterized in that** the shield layer includes Al or TiN.

10. The quantum device as claimed in claim 1 or 2, **characterized in that**:
the first qubit substrate includes a first substrate having a dielectric loss of 1 x 10⁻³ or less,
the second qubit substrate includes a second substrate having a dielectric loss of 1 x 10⁻³ or less,
the first qubit and the first electrode are provided on a side of the first substrate adjacent to the capacitive coupling substrate, and
the second qubit and the second electrode are provided on a side of the second substrate adjacent to the capacitive coupling substrate.

11. The quantum device as claimed in claim 10, **characterized in that**:
the first substrate is a silicon substrate, a sapphire substrate, or a MgO substrate, and
the second substrate is a silicon substrate, a sapphire substrate, or a MgO substrate.

12. The quantum device as claimed in claim 1 or 2, **characterized in that**:
the capacitive coupling substrate includes a third substrate having a dielectric loss of 1 x 10⁻³ or less, and
the shield layer is provided on a side of the first qubit substrate and the second qubit substrate adjacent to the third substrate.

13. The quantum device as claimed in claim 12, **characterized in that** the third substrate is a silicon substrate, a sapphire substrate, or a MgO substrate.

14. A method for manufacturing a quantum device, **characterized in that** there are provided the steps of:
preparing a first qubit substrate having a first qubit and a first electrode coupled to the first qubit;
preparing a second qubit substrate having a second qubit and a second electrode coupled to the second qubit;
preparing a capacitive coupling substrate including a third electrode, a shield layer, and an insulating film provided between the third electrode and the shield layer; and
bonding the first qubit substrate and the second qubit substrate to the capacitive coupling substrate so that the third electrode opposes the first electrode and the second electrode and the shield layer covers the first qubit and the second qubit.
